# FASCICULE DE BREVET EUROPEEN

(11) **EP 2 844 052 B1**
(45) Date de publication et mention de la délivrance du brevet: **22.03.2017**
(21) Numéro de dépôt: 14181451.7
(22) Date de dépôt: 19.08.2014
(51) Int. Cl.: H05K 7/20, H01L 23/473

(54) **Bloc convertisseur de puissance de véhicule électrique ou hybride**
Leistungswandlerblock für Elektro- oder Hybridfahrzeug
Power converter unit of an electric or hybrid vehicle

(30) Priorité: 27.08.2013 FR 1358192
(43) Date de publication de la demande: 04.03.2015
(73) Titulaire: VALEO EQUIPEMENTS ELECTRIQUES MOTEUR, 94046 Créteil Cedex (FR)
(72) Inventeur: Tan, Ky Lim, 94700 Maison Alfort (FR); Brisset, Anthony, 78310 Maurepas (FR); Leloup, Olivier, 77173 Chevry-Cossigny (FR); Morelle, Jean-Michel, 45190 Beaugency (FR)

(56) Documents cités:
- EP-A1- 0 543 084
- EP-A1- 0 771 138
- EP-A1- 2 291 067
- EP-A2- 0 821 468
- EP-A2- 1 906 447
- EP-A2- 2 469 996
- WO-A1-2012/101384
- FR-A1- 2 861 894
- US-A1- 2003 117 824
- US-A1- 2012 111 553
- US-B1- 6 212 074

## Description

### DOMAINE TECHNIQUE DE L'INVENTION.

La présente invention concerne un bloc convertisseur de puissance de véhicule électrique ou hybride, notamment un bloc convertisseur de puissance de courant continu en courant continu réversible pour les applications aux véhicules électriques ou hybrides.

### ARRIERE PLAN TECHNOLOGIQUE DE L'INVENTION.

Les véhicules automobiles à moteur thermique comportent classiquement un réseau électrique de bord comprenant une batterie, généralement de 12 V, destiné à alimenter en énergie électrique les divers équipements, notamment un démarreur, indispensable pour assurer le démarrage du moteur thermique. Après le démarrage, un alternateur accouplé au moteur thermique assure la charge de la batterie.

De nos jours, le développement de l'électronique de puissance permet de réaliser un bloc convertisseur de puissance alternatif/ continu réversible, c'est-à-dire fonctionnant soit en redresseur, soit en onduleur pour alimenter une seule machine électrique tournante polyphasée réversible qui remplace avantageusement le démarreur et l'alternateur.

Dans un premier temps, cette machine, connue sous le nom d'alterno-démarreur, avait essentiellement pour but de remplir les fonctions autrefois dédiées à l'alternateur et au démarreur, et, accessoirement, de récupérer l'énergie au freinage, ou d'apporter un supplément de puissance et de couple au moteur thermique.

Dans le but d'accroître la puissance et d'améliorer le rendement de l'alterno-démarreur en augmentant sa tension de fonctionnement tout en conservant la possibilité d'utiliser des autres équipements standards, prévus pour une alimentation de 12 V à 14 V, notamment les batteries au plomb, a été développée une architecture de réseau bitension.

Cette architecture consiste donc en un réseau électrique de puissance reliant l'alterno-démarreur à un élément de stockage d'énergie électrique fonctionnant à une tension supérieure à 14 V, pouvant atteindre 48 V, et en un réseau électrique de service reliant tous les autres équipements. L'adaptation des niveaux de tensions entre les deux réseaux est assurée par un bloc convertisseur de puissance continu/ continu réversible.

Un tel convertisseur continu/ continu réversible est par exemple décrit dans la demande de brevet FR2833113 de la société VALEO EQUIPEMENTS ELECTRIQUES MOTEUR.

Dans un second temps, des considérations écologiques, ont conduit à concevoir des alterno-démarreurs ayant une puissance, de l'ordre de 8 à 10 KW, suffisante pour entraîner le véhicule à faible vitesse, par exemple en environnement urbain.

De telles puissances n'ont pu être obtenues, tout en conservant des machines électriques compactes, qu'en portant la tension du réseau électrique de puissance à une tension, de l'ordre de 60 V, bien supérieure à la tension nominale des batteries au plomb classiques.

Par ailleurs, des réseaux de puissance à des tensions allant jusqu'à 120V peuvent être mis en oeuvre dans une architecture qui permet au véhicule d'être entraîné à pleine vitesse par le moteur électrique (architecture dite "full-hybrid" en terminologie anglaise, par comparaison à l'architecture précédente dite "mild-hybrid").

Compte tenu des niveaux de puissance requis, les convertisseurs utilisés dans ces applications ne sont généralement plus réalisés sous forme de modules intégrant des composants électroniques sur des circuits imprimés en époxy (de type FR4), mais font appel à la technologie du substrat métallique isolé (IMS en terminologie anglaise, pour "Insulated Métal Substrate") qui permet une meilleure dissipation thermique, telle que décrite par exemple dans la demande de brevet FR2721161 de la société VALEO ELECTRONIQUE.

Un tel substrat comporte trois couches: une première couche est constituée d'une trace métallique de cuivre très fine formant les liaisons électriques du circuit, une deuxième couche intermédiaire est une plaque de résine, et une troisième couche est une plaque métallique en aluminium.

Le substrat peut également être de type DBC (acronyme de "Direct Bounded Copper" en terminologie anglaise, c'est-à-dire "cuivre à liaison directe"). Dans ce cas la plaque de résine est remplacée par une plaque de céramique, et la troisième couche est une plaque métallique constituée de cuivre ou de cuivre nickelé.

La plaque métallique, en aluminium pour l'IMS ou en cuivre pour le DBC, comporte une face de refroidissement destinée à être mise en contact avec des moyens de refroidissement par air, le plus souvent un dissipateur thermique métallique à ailettes.

De tels moyens de refroidissement par air peuvent présenter une capacité de refroidissement insuffisante dans le cas d'un bloc convertisseur de forte puissance pour un véhicule électrique ou hybride, et, afin de pallier cet inconvénient, la société VALEO EQUIPEMENTS MOTEUR a divulgué dans sa demande de brevet FR2861894 un dispositif de refroidissement par circulation d'un liquide dans un circuit de refroidissement en contact avec l'électronique de puissance.

Des dispositifs de refroidissement de blocs convertisseur de puissance par circulation de liquide de ce type sont une solution technique retenue dans les équipements embarqués de hautes performances, comme le montre le rapport concernant les barrières à l'application des liquides de refroidissement à haute température dans les véhicules électriques hybrides: "Barriers to the application of high temperature coolants in hybrid electric vehicles", John Hsu et al., ORNL/TM-2006/514, Oak Ridge National Laboratory,septembre 2006.

Cependant, cette solution, si elle est très efficace, est très complexe, et peu compacte, car des moyens annexes de mise en circulation du liquide de refroidissement extérieurs au circuit de refroidissement, tels qu'une pompe, sont nécessaires.

Le document US 2003/0117824 divulgue un convertisseur de puissance pour un système de traction électrique, pourvu d'un plateau-support, sur lequel sont montés des composants électroniques, et d'un système de refroidissement dans lequel circule un fluide caloporteur ayant une phase liquide et une phase gazeuse. Le système de refroidissement est pourvu d'un réseau d'ailettes et d'une chambre contenant le fluide caloporteur.

Il existe donc un besoin pour un bloc convertisseur de puissance de véhicule électrique ou hybride muni d'un système de refroidissement efficace qui ne présente pas les inconvénients mentionnés ci-dessus.

### DESCRIPTION GENERALE DE L'INVENTION.

La présente invention vise à répondre à ce besoin avec un bloc convertisseur de puissance de véhicule électrique ou hybride du type de ceux comprenant des composants électroniques de puissance montés sur un plateau-support et un système de refroidissement comportant au moins un dissipateur thermique métallique et au moins un circuit de refroidissement par circulation d'un fluide caloporteur en contact avec le plateau-support, le circuit de refroidissement comportant au moins une première zone de transition en phase gazeuse et au moins une seconde zone de transition en phase liquide du fluide caloporteur.

Conformément à l'invention, la première zone de transition et la seconde zone de transition sont comprises dans une chambre métallique, la chambre métallique étant formée par un évidement s'étendant à la base des ailettes du dissipateur thermique et fermé par une plaque métallique formant la seconde face.

Selon une autre caractéristique, la plaque métallique est fixée par brasage ou collage sur le dissipateur thermique métallique.

Dans un premier mode de réalisation général de l'invention, la chambre métallique est de forme sensiblement parallélépipédique et présente une première face en contact avec le dissipateur thermique métallique muni d'un premier réseau d'ailettes et une seconde face opposée constituant le plateau-support.

Dans cette première configuration, le fluide caloporteur circule par convection naturelle dans la chambre métallique.

Selon une autre caractéristique, la seconde face de la chambre métallique comporte au moins en partie une couche d'interface électriquement isolante et thermiquement conductrice supportant les composants électroniques de puissance.

En variante, la chambre métallique est fort avantageusement intégrée dans le dissipateur thermique métallique.

Dans le bloc convertisseur de puissance de véhicule électrique ou hybride selon l'invention, les composants électroniques de puissance sont montés de préférence sur le plateau-support au moyen de goujons filetés et/ ou de vis solidaires du plateau-support ou du dissipateur thermique métallique.

Au moins un de ces composants électroniques de puissance est avantageusement monté sur le plateau-support par l'intermédiaire d'une lame métallique élastique engagée sur l'un de ces goujons ou l'une de ces vis.

De préférence, ces composants électroniques de puissance comprennent au moins un module électronique de puissance monté au moyen de cette lame métallique élastique, des éléments à semi-conducteur discrets en boîtier de type TO247 montés au moyens des goujons ou des vis, et des éléments inductifs dans au moins un bac rempli de résine.

Les ailettes du dissipateur thermique métallique sont préférentiellement cylindriques ou tronconiques et de type moulées, extrudées ou forgées.

Dans le bloc convertisseur de puissance de véhicule électrique ou hybride selon l'invention, on tire bénéfice du fait que la plaque métallique est constituée de cuivre, la chambre métallique est constituée au moins partiellement de cuivre, le dissipateur métallique est constitué d'aluminium, et le carter est constitué au moins partiellement d'aluminium.

De préférence, le fluide caloporteur est de l'eau.

L'invention concerne aussi l'utilisation de ce bloc convertisseur de puissance de véhicule électrique ou hybride, dans lequel le fluide caloporteur est de l'eau, dans une température ambiante comprise entre - 40 °C et + 120°C.

Dans le cas du premier mode de réalisation, le plateau-support est avantageusement agencé horizontalement dans le véhicule, de manière à ce que le dissipateur thermique métallique soit situé au dessus du plateau-support.

Ces quelques spécifications essentielles auront rendu évidents pour l'homme de métier les avantages apportés par ce bloc convertisseur de puissance par rapport à l'état de la technique antérieur.

Les spécifications détaillées de l'invention sont données dans la description qui suit en liaison avec les dessins ci-annexés. Il est à noter que ces dessins n'ont d'autre but que d'illustrer le texte de la description et ne constituent en aucune sorte une limitation de la portée de l'invention.

### BREVE DESCRIPTION DES DESSINS.

La **Figure 1** est une vue éclatée du bloc convertisseur de puissance de véhicule électrique ou hybride dans un premier mode de réalisation préféré de l'invention.
Les **Figures 2a et 2b** sont respectivement une vue de dessus et une vue en coupe transversale du bloc convertisseur de puissance montré sur la **Figure 1****.**
Les **Figures 3a, 3b** **et** **3c** montrent respectivement le montage d'un module électronique de puissance du bloc convertisseur de puissance montré sur la **Figure** 1, et, de manière détaillée, ce module électronique de puissance en perspective et en coupe.
La **Figure 4** est une vue en coupe transversale d'une variante du bloc convertisseur de puissance montré sur la **Figure 1****.**
Les **Figures 5a et 5b** sont respectivement une vue de dessus et une vue en coupe transversale du bloc convertisseur de puissance de véhicule électrique ou hybride dans un second mode de réalisation préféré de l'invention.

### DESCRIPTION DES MODES DE REALISATION PREFERES DE L'INVENTION.

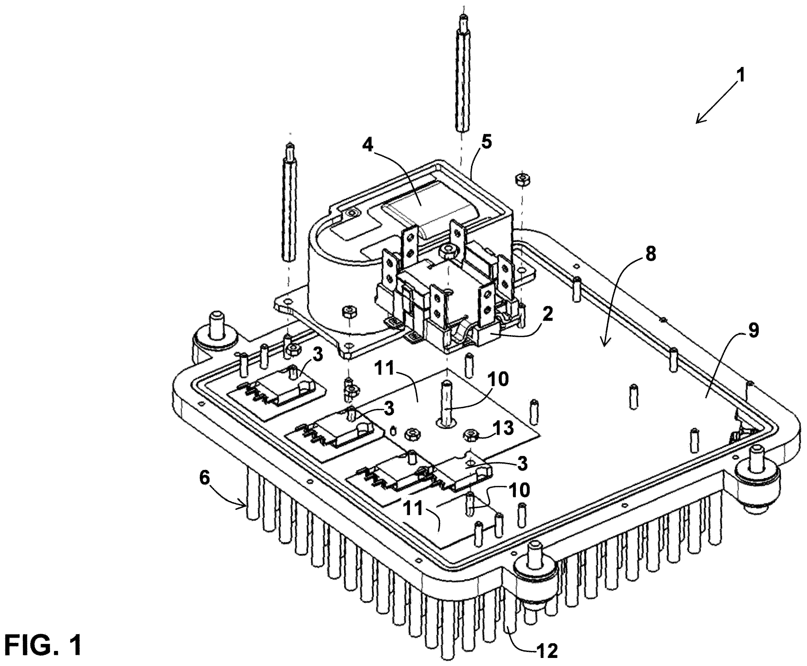

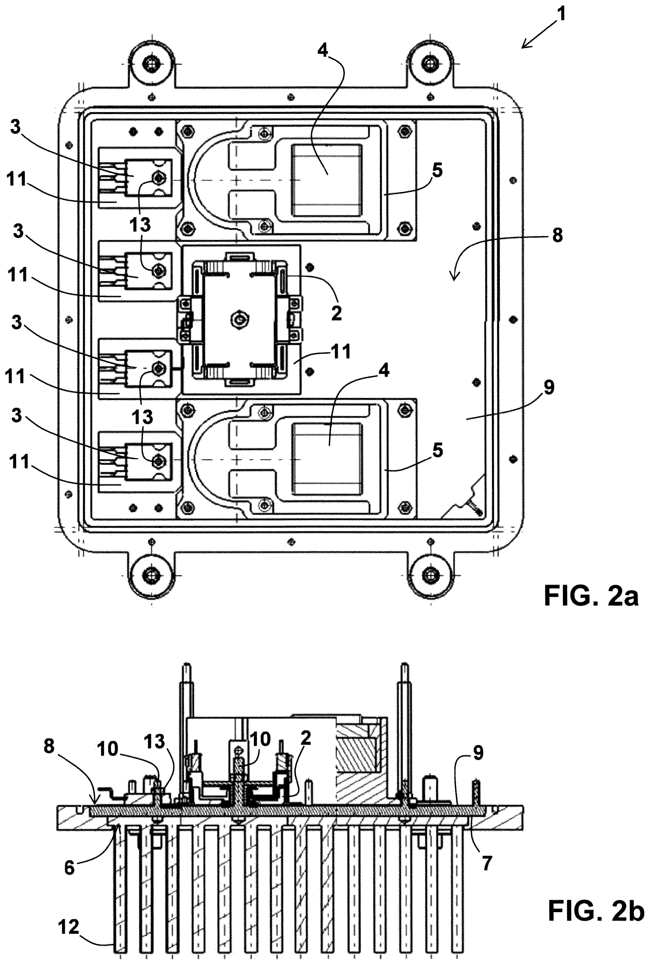

Le bloc convertisseur de puissance 1 selon l'invention est de préférence un convertisseur courant continu/ courant continu qui comprend différents composants électroniques de puissance 2, 3, 4, comme le montre bien la vue éclatée de la **Figure 1** ou la vue de dessus de la **Figure 2a****:**
- un module électronique de puissance 2;
- quatre éléments à semi-conducteur discrets 3 en boîtier de type TO247 (MOSFET de puissance);
- deux éléments inductifs 4, chacun dans un bac 5 rempli de résine.

Le bloc convertisseur 1 est refroidi par un dissipateur thermique 6 en aluminium.

Dans un premier mode de réalisation préféré de l'invention, comme le montre bien la vue en coupe de la **Figure 2b****,** ce dissipateur thermique 6 est en contact avec une première face 7 d'une chambre métallique 8 parallélépipédique dont une seconde face opposée 9 constitue un plateau-support sur lequel sont montés les composants électroniques 2, 3, 4 au moyen de goujons filetés 10.

Le contact thermique entre le dissipateur thermique 6 et la première face 7 de la chambre métallique 8 est assuré par brasage ou par collage au moyen d'une colle thermiquement conductrice.

Les composants électroniques de puissance 2, 3, 4 sont isolés électriquement de la chambre métallique 8 par une couche d'interface 11 électriquement isolante et thermiquement conductrice.

De manière à bénéficier des effets de flux d'air ambiant omnidirectionnels, le dissipateur thermique 6 est muni d'un réseau d'ailettes 12 cylindriques.

Une résistance thermique entre les composants électroniques 2, 3, 4 et le dissipateur thermique 6 est diminuée grâce à une circulation d'eau par convection à l'intérieur de la chambre 8, entre la première face 7 où l'eau se condense à une température nominale du dissipateur thermique 6, et la seconde face 9 où l'eau se vaporise à une température de fonctionnement des composants électroniques de puissance 2, 3, 4.

La chambre métallique 8 servant de support aux composants électriques de puissance 2, 3, 4 permet une bonne répartition thermique entre les circuits électriques primaire et secondaire du convertisseur CC/ CC en évitant la présence de points chauds.

Pour contribuer également à la bonne répartition thermique, une pression de placage sur le plateau-support 9 des composants électroniques de puissance 2, 3, 4 est prédéterminée en fonction des caractéristiques thermiques de ces composants 2, 3, 4.

Pour chacun des semi-conducteurs de type MOSFET 3 en boîtier TO247, la pression de placage est réglée en ajustant le couple de serrage d'un boulon 13 sur le goujon fileté 10 correspondant.

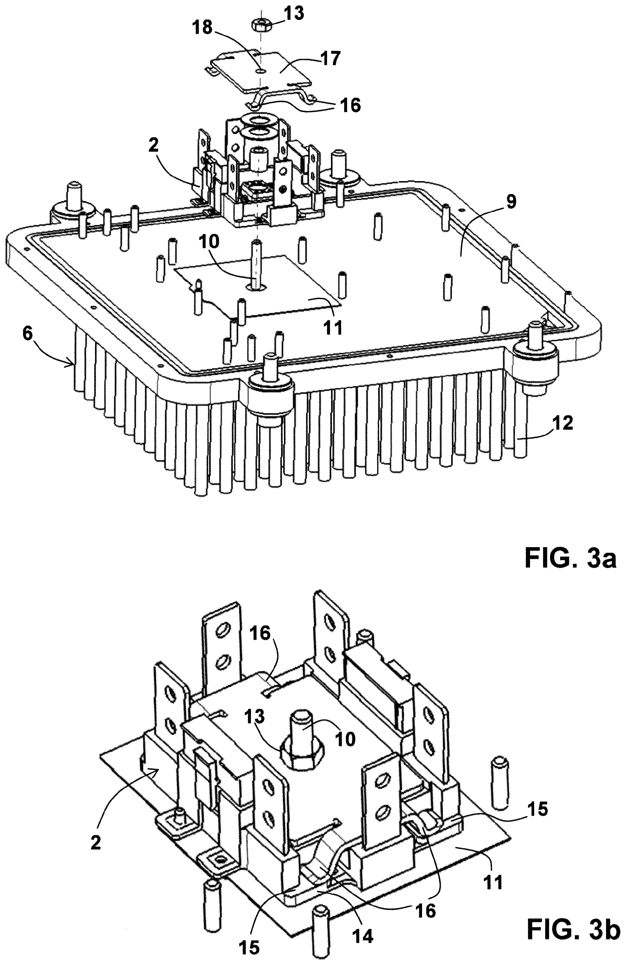

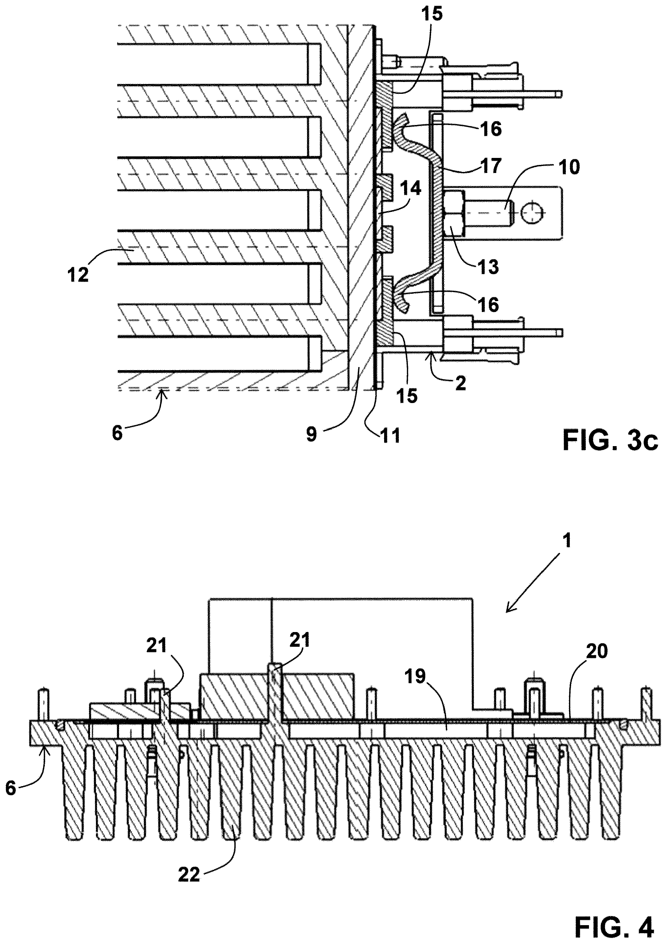

Pour le module électronique de puissance 2, cette pression de placage est réglée par un montage spécifique bien montré sur les **Figures 3a, 3b** **et** **3c****.**

Des bords d'un substrat 14 du module électronique de puissance 2 comportent des surfaces d'appui 15 pour des pattes 16 d'une lame métallique élastique 17 sensiblement rectangulaire munie d'un trou central 18.

La lame métallique 17 étant engagée axialement par ce trou central 18 sur un autre goujon fileté 10 correspondant traversant le module électronique de puissance 2, le déplacement axial d'un autre boulon 13 permet de faire varier la pression des pattes 16 sur les surfaces d'appui 15, et par conséquent la pression de placage.

En variante de ce premier mode de réalisation préféré du bloc convertisseur de puissance 1, le dissipateur thermique 6 comprend un évidement 19 s'étendant à la base des ailettes 12 comme le montre la **Figure 4****.**

Cet évidement 19 est fermé par une plaque métallique 20 de manière à former une chambre équivalente 8 dans laquelle l'eau circule par convection en se transformant cycliquement en gaz et en liquide.

Dans cette variante, la chambre métallique 8 étant intégrée au dissipateur thermique 6, une résistance thermique due à l'assemblage du dissipateur thermique 6 et de la chambre métallique 8 est supprimée.

La plaque métallique 20 en cuivre est fixée par brassage ou collage sur le dissipateur thermique 6.

Certains goujons filetés 21 de fixation des composant électroniques de puissance 2, 3, 4, tels que celui maintenant le module électronique de puissance 2, sont formés directement à partir de la pièce de fonderie monobloc du dissipateur thermique 6.

Dans cette variante, les ailettes 22 sont tronconiques plutôt que cylindriques.

Un second mode de réalisation préféré du bloc convertisseur de puissance 1 permet de satisfaire à la fois à des exigences de limitation des coûts et de températures de fonctionnement élevées.

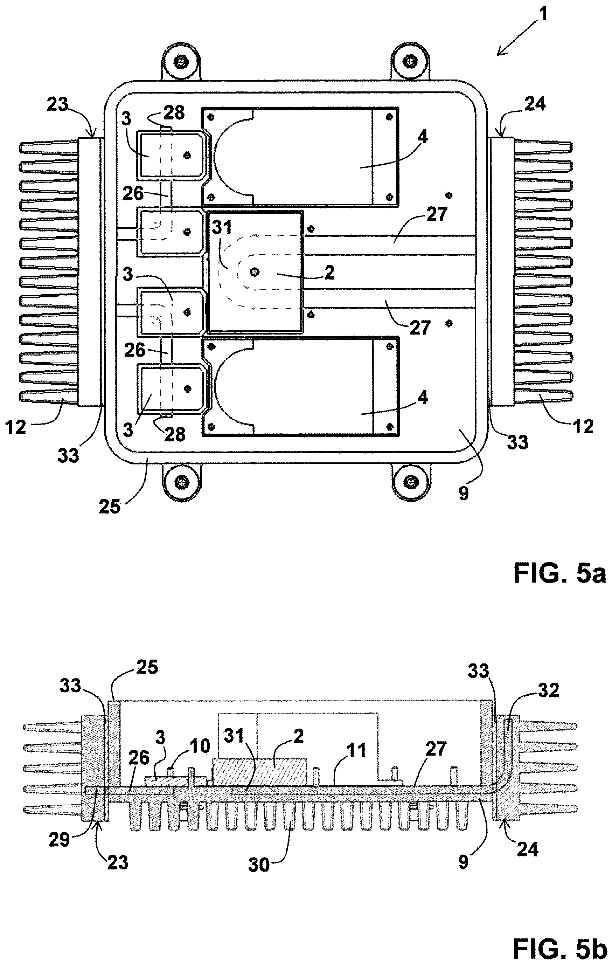

Comme le montrent bien les **Figures 5a et 5b****,** le bloc convertisseur de puissance 1 selon l'invention comporte des dissipateurs thermiques latéraux 23, 24 en aluminium fixés sur un carter 25.

Ces dissipateurs thermiques latéraux 23, 24, munis d'un autre réseau d'ailettes 12, sont reliés thermiquement par des tubes en cuivre 26, 27, aplatis, de section sensiblement rectangulaire, à certains composants électroniques de puissance 2, 3.

Deux 26 de ces tubes 26, 27 ont leurs premières extrémités 28 en contact thermique avec les éléments à semi-conducteur discrets 3 et leurs secondes extrémités 29 en contact thermique avec le premier 23 de ces dissipateurs thermiques latéraux 23, 24.

Comme le montre bien la **Figure 5b****,** en dehors de leurs secondes extrémité 29, ces deux tubes 26 sont également en contact thermique avec le plateau-support 9 qui forme une partie du carter 25, et qui est muni extérieurement d'éléments dissipatifs métalliques 30.

Ces deux tubes 26 sont coudés dans un plan du plateau-support 9 afin de refroidir deux éléments à semi-conducteur discrets 3 chacun.

Une conductibilité thermique de ces deux tubes 26 est augmentée grâce à une circulation d'eau par capillarité à l'intérieur, entre leurs premières extrémités 28 où l'eau se vaporise à la température de fonctionnement des composants électroniques de puissance 2, 3, et leurs secondes extrémités 29 où l'eau se condense à une première température du premier 23 des dissipateurs thermiques latéraux 23, 24.

De la même manière, deux autres 27 de ces tubes 26, 27 ont leurs autres premières extrémités 31 en contact thermique avec le module électronique de puissance 2 et leurs autres secondes extrémités 32 en contact thermique avec le second 24 de ces dissipateurs thermiques latéraux 23, 24.

Ces deux autres tubes 27 sont coudés, d'une part dans un plan vertical en s'étendant parallèlement au carter 25, et, d'autre part dans un plan horizontal en s'étendant sous le module électronique de puissance 2.

Comme le montre bien la **Figure 5b****,** en dehors de leurs autres secondes extrémités 32, ces deux tubes 27 sont également en contact thermique avec le plateau-support 9.

La conductibilité thermique de ces deux autres tubes 27 est augmentée grâce à une circulation d'eau par capillarité à l'intérieur, entre leurs autres premières extrémités 31 où l'eau se vaporise à la température de fonctionnement du module électronique de puissance 2, et leurs autres secondes extrémités 32 où l'eau se condense à une seconde température du second 24 des dissipateurs thermiques latéraux 23, 24.

Comme le montre bien la **Figure 5a****,** ces deux autres tubes 27 sont constitués pratiquement par un tube unique coudé symétriquement, dont les deux moitiés fonctionnent comme deux tubes indépendants.

Les dissipateurs latéraux 23, 24 sont séparés thermiquement du carter 25 par une couche intercalaire 33 constituée d'un isolant électrique.

Dans ce second mode de réalisation, les composants électroniques de puissance 2, 3, 4 sont également isolés électriquement des tubes 26, 27 et du plateau-support 9 par une couche d'interface 11 électriquement isolante et thermiquement conductrice.

L'utilisation de l'eau comme fluide caloporteur permet un fonctionnement du bloc convertisseur de puissance 1 dans une température ambiante comprise entre - -40 °C et + 120 °C.

Compte tenu de la circulation du fluide par convection naturelle, dans le premier mode de réalisation, le bloc convertisseur de puissance 1 doit être agencé dans le véhicule de manière à ce que le plateau-support 9 soit sensiblement horizontal, le dissipateur thermique 6 étant situé au dessus.

Dans le second mode de réalisation, le fluide caloporteur circulant par capillarité, les possibilités d'installation dans le véhicule du bloc convertisseur de puissance 1 sont plus grandes.

Comme il va de soi, l'invention ne se limite pas aux seuls modes d'exécution préférentiels décrits ci-dessus.

Notamment, la forme de la chambre métallique 8, celle du carter 25, les formes des tubes métalliques 26, 27, celles des dissipateurs thermiques 6, 23, 24 , du plateau-support 9 et de leurs ailettes 12, 22 ou des éléments dissipatifs 30, et les caractéristiques des composants électroniques cités 2, 3, 4 spécifiées, ou représentées, ne sont que des exemples de réalisation.

Les goujons 10, 21, vis, boulons 13 et lames métalliques 17 permettant le montage des composants électroniques de puissance 2, 3, 4 ne sont pas non plus limitatifs: d'autres moyens de montage sont alternativement mis en oeuvre.

La description porte sur un bloc convertisseur de puissance 1 CC/ CC. Une description analogue pourrait porter sur un onduleur, un redresseur synchrone, ou un convertisseur CA/ CC réversible de puissance.

Enfin, la gamme de températures ambiantes indiquée correspond à une application embarquée particulière.

L'utilisation d'un fluide caloporteur différent de l'eau permettrait éventuellement une mise en oeuvre du bloc convertisseur de puissance 1 selon l'invention dans d'autres conditions environnementales.

L'invention embrasse donc toutes les variantes possibles de réalisation dans la mesure où ces variantes restent dans le cadre défini par les revendications ci-après.

## Revendications

1. Bloc convertisseur de puissance (1) de véhicule électrique ou hybride du type de ceux comprenant des composants électroniques de puissance (2, 3, 4) montés sur un plateau-support (9) et un système de refroidissement comportant au moins un dissipateur thermique métallique (6, 23, 24) muni d'un réseau d'ailettes (12, 22) et au moins un circuit de refroidissement par circulation d'un fluide caloporteur en contact avec ledit plateau-support (9), ledit circuit de refroidissement comportant au moins une première zone de transition en phase gazeuse et au moins une seconde zone de transition en phase liquide dudit fluide caloporteur, ladite première zone de transition et ladite seconde zone de transition sont comprises dans une même chambre métallique (8), **caractérisé en ce que** ladite chambre métallique (8) étant intégrée dans ledit dissipateur thermique métallique (6), étant de forme sensiblement parallélépipédique et étant formée par un évidement (19) s'étendant à la base desdites ailettes (22), ladite chambre métallique (8) présentant une première face (7) en contact avec ledit dissipateur thermique métallique (6) et une seconde face (9) opposée constituant ledit plateau-support qui est formé par une plaque métallique (20) fermant ledit évidement (9), et ledit fluide caloporteur circulant par convection naturelle dans ladite chambre métallique (8).

2. Bloc convertisseur de puissance (1) de véhicule électrique ou hybride selon la revendication 1, **caractérisé en ce que** ladite seconde face (9) comporte au moins en partie une couche d'interface (11) électriquement isolante et thermiquement conductrice supportant lesdits composants électroniques de puissance (2, 3, 4).

3. Bloc convertisseur de puissance (1) de véhicule électrique ou hybride selon la revendication 1 ou 2 précédente, **caractérisé en ce que** lesdits composants électroniques de puissance (2, 3, 4) sont montés sur ledit plateau-support (9) au moyen de goujons filetés (10, 21) et/ ou de vis solidaires dudit plateau-support (9) ou dudit dissipateur thermique métallique (6).

4. Bloc convertisseur de puissance (1) de véhicule électrique ou hybride selon la revendication 3, **caractérisé en ce qu'**au moins un (2) desdits composants électroniques de puissance (2, 3, 4) est monté sur ledit plateau-support (9) par l'intermédiaire d'une lame métallique élastique (17) engagée sur l'un desdits goujons filetés (10) ou l'une desdites vis.

5. Bloc convertisseur de puissance (1) de véhicule électrique ou hybride selon la revendication 4, **caractérisé en ce que** lesdits composants électroniques de puissance (2, 3, 4) comprennent au moins un module électronique de puissance (2) monté au moyen de ladite lame métallique élastique (17), des éléments à semi-conducteur discrets (3) en boîtier de type TO247 montés au moyens desdits goujons filetés (10) ou desdites vis, et des éléments inductifs (4) dans au moins un bac (5) rempli de résine.

6. Bloc convertisseur de puissance (1) de véhicule électrique ou hybride selon l'une quelconque des revendications 1 à 5 précédentes, **caractérisé en ce que** lesdites ailettes (12, 22) sont cylindriques ou tronconiques et de type moulées, extrudées ou forgées.

7. Bloc convertisseur de puissance (1) de véhicule électrique ou hybride selon l'une quelconque des revendications 1 à 6 précédentes, **caractérisé en ce que** ledit fluide caloporteur est de l'eau.

8. Utilisation du bloc convertisseur de puissance de véhicule électrique ou hybride selon la revendication 7, **caractérisé en ce que** ledit plateau-support (9) est agencé horizontalement dans ledit véhicule, ledit dissipateur thermique métallique étant orienté de manière à être situé au dessus dudit plateau-support (9), et **en ce qu'**une température ambiante est comprise entre - 40 °C et + 120°C.

## Patentansprüche

1. Leistungswandlerblock (1) für Elektro- oder Hybridfahrzeug des Typs von jenen, die elektronische Leistungsbauteile (2, 3, 4), die auf einer Trägerplatte (9) befestigt sind, und ein Kühlsystem aufweisen, das mindestens eine metallische Wärmesenke (6, 23, 24), die mit einem Netzwerk von Rippen (12, 22) versehen ist, und mindestens einen Kühlkreislauf durch Zirkulation eines Wärmeträgerfluids in Kontakt mit der Trägerplatte (9) aufweist, wobei der Kühlkreislauf mindestens einen ersten Übergangsbereich in die Gasphase und mindestens einen zweiten Übergangsbereich in die Flüssigphase des Wärmeträgerfluids aufweist, wobei der erste Übergangsbereich und der zweite Übergangsbereich in einer gleichen Metallkammer (8) enthalten sind, **dadurch gekennzeichnet, dass** die Metallkammer (8) in der metallischen Wärmesenke (6) integriert ist, von im Wesentlichen parallelepipedischer Form ist und durch eine Ausnehmung (19) gebildet ist, die sich an der Basis der Rippen (22) erstreckt, wobei die Metallkammer (8) eine erste Fläche (7) in Kontakt mit der metallischen Wärmesenke (6) und eine zweite gegenüberliegende Fläche (9) aufweist, die die Trägerplatte bildet, die durch eine Metallplatte (20) gebildet ist, die die Ausnehmung (9) schließt, und wobei das Wärmeträgerfluid durch natürliche Konvektion in der Metallkammer (8) zirkuliert.

2. Leistungswandlerblock (1) für Elektro- oder Hybridfahrzeug nach Anspruch 1, **dadurch gekennzeichnet, dass** die zweite Fläche (9) mindestens teilweise eine elektrisch isolierende und wärmeleitende Schnittstellenschicht (11) aufweist, die die elektronischen Leistungsbauteile (2, 3, 4) trägt.

3. Leistungswandlerblock (1) für Elektro- oder Hybridfahrzeug nach dem vorhergehenden Anspruch 1 oder 2, **dadurch gekennzeichnet, dass** die elektronischen Leistungsbauteile (2, 3, 4) mittels Gewindebolzen (10, 21) und/oder Schrauben, die mit der Trägerplatte (9) oder der metallischen Wärmesenke (6) fest verbunden sind, auf der Trägerplatte (9) befestigt sind.

4. Leistungswandlerblock (1) für Elektro- oder Hybridfahrzeug nach Anspruch 3, **dadurch gekennzeichnet, dass** mindestens eines (2) der elektronischen Leistungsbauteile (2, 3, 4) mittels einer elastischen Metallklinge (17), die in einen der Gewindebolzen (10) oder eine der Schrauben eingreift, auf der Trägerplatte (9) befestigt ist.

5. Leistungswandlerblock (1) für Elektro- oder Hybridfahrzeug nach Anspruch 4, **dadurch gekennzeichnet, dass** die elektronischen Leistungsbauteile (2, 3, 4) mindestens ein elektronisches Leistungsmodul (2), das mittels der elastischen Metallklinge (17) befestigt ist, diskrete Halbleiterelemente (3) im T0247-Gehäuse, die mittels der Gewindebolzen (10) oder der Schrauben befestigt sind, und induktive Elemente (4) in mindestens einem Behälter (5), der mit Harz gefüllt ist, aufweisen.

6. Leistungswandlerblock (1) für Elektro- oder Hybridfahrzeug nach einem der vorhergehenden Ansprüche 1 bis 5, **dadurch gekennzeichnet, dass** die Rippen (12, 22) zylindrisch oder kegelstumpfförmig und vom geformten, extrudierten oder geschmiedeten Typ sind.

7. Leistungswandlerblock (1) für Elektro- oder Hybridfahrzeug nach einem der vorhergehenden Ansprüche 1 bis 6, **dadurch gekennzeichnet, dass** das Wärmeträgerfluid Wasser ist.

8. Verwendung eines Leistungswandlerblocks für Elektro- oder Hybridfahrzeug nach Anspruch 7, **dadurch gekennzeichnet, dass** die Trägerplatte (9) horizontal in dem Fahrzeug angeordnet ist, wobei die metallische Wärmesenke derart ausgerichtet ist, dass sie über der Trägerplatte (9) angeordnet ist, und dass eine Umgebungstemperatur zwischen -40 °C und +120 °C liegt.

## Claims

1. Power converter unit (1) of an electric or hybrid vehicle of the type of those comprising power electronics components (2, 3, 4) mounted on a support plate (9) and a cooling system comprising at least one metal heat sink (6, 23, 24) equipped with an array of fins (12, 22) and at least one cooling circuit working by circulating a heat-transfer fluid in contact with the said support plate (9), the said cooling circuit comprising at least a first transition zone in which the said heat-transfer fluid makes the transition to the gaseous phase and at least one second transition zone in which the heat-transfer fluid makes the transition to the liquid phase, the said first transition zone and the said second transition zone being comprised in one and the same metallic chamber (8), **characterized in that** the said metallic chamber (8) is incorporated into the said metallic heat sink (6), being of substantially parallelepipedal shape and being formed by a recess (19) extending at the base of the said fins (22), the said metallic chamber (8) having a first face (7) in contact with the said metallic heat sink (6) and an opposite second face (9) constituting the said support plate which is formed of a metallic sheet (20) closing the said recess (9), and the said heat-transfer fluid circulating in the said metallic chamber (8) by natural convection.

2. Power converter unit (1) of an electric or hybrid vehicle according to Claim 1, **characterized in that** the said second face (9) comprises at least in part an electrically insulating and thermally conducting interface layer (11) supporting the said power electronics components (2, 3, 4).

3. Power converter unit (1) of an electric or hybrid vehicle according to the preceding Claim 1 or 2, **characterized in that** the said power electronics components (2, 3, 4) are mounted on the said support plate (9) by means of threaded studs (10, 21) and/or of screws secured to the said support plate (9) or to the said metallic heat sink (6).

4. Power converter unit (1) of an electric or hybrid vehicle according to Claim 3, **characterized in that** at least one (2) of the said power electronics components (2, 3, 4) is mounted on the said support plate (9) by means of an elastic metallic leaf (17) engaged over one of the said threaded studs (10) or one of the said screws.

5. Power converter unit (1) of an electric or hybrid vehicle according to Claim 4, **characterized in that** the said power electronics components (2, 3, 4) comprise at least one power electronics module (2) mounted by means of the said elastic metallic leaf (17), discrete case-packaged semiconductor elements (3) of the T0247 type, mounted by means of the said threaded studs (10) or of the said screws, and inductive elements (4) in at least one resin-filled tub (5).

6. Power converter unit (1) of an electric or hybrid vehicle according to any one of the preceding Claims 1 to 5, **characterized in that** the said fins (12, 22) are cylindrical or frustoconical and of moulded, extruded or forged type.

7. Power converter unit (1) of an electric or hybrid vehicle according to any one of the preceding Claims 1 to 6, **characterized in that** the said heat-transfer fluid is water.

8. Use of the power converter unit of an electric or hybrid vehicle according to Claim 7, **characterized in that** the said support plate (9) is arranged horizontally in the said vehicle, the said metallic heat sink being oriented in such a way as to be situated above the said support plate (9), and **in that** an ambient temperature is comprised between -40°C and +120°C.
